# EUROPÄISCHE PATENTSCHRIFT

(11) **EP 2 513 993 B1**
(45) Veröffentlichungstag und Bekanntmachung des Hinweises auf die Patenterteilung: **13.05.2015**
(21) Anmeldenummer: 10795312.7
(22) Anmeldetag: 15.12.2010
(51) Int. Cl.: H01L 41/187, H01L 41/083, H01L 41/43, C04B 35/491, C04B 35/493

(54) **PIEZOELEKTRISCHES KERAMIKMATERIAL, DESSEN HERSTELLUNGSVERFAHREN UND VIELSCHICHTBAUELEMENT**
PIEZOELECTRIC CERAMIC MATERIAL, METHOD FOR THE PRODUCTION THEREOF, AND MULTILAYER COMPONENT
MATÉRIAU CÉRAMIQUE PIÉZOÉLECTRIQUE, SON PROCÉDÉ DE FABRICATION ET COMPOSANT MULTICOUCHE

(30) Priorität: 18.12.2009 DE 102009058795
(43) Veröffentlichungstag der Anmeldung: 24.10.2012
(73) Patentinhaber: Epcos AG, 81669 München (DE)
(72) Erfinder: SCHOSSMANN, Michael, A-8523 Frauental (AT); FELTZ, Adalbert, A-8530 Deutschlandsberg (AT)
(74) Vertreter: Epping - Hermann - Fischer
(86) Internationale Anmeldenummer: PCT/EP2010/069789
(87) Internationale Veröffentlichungsnummer: WO 2011/073270

(56) Entgegenhaltungen:
- WO-A1-2006/110722
- DE-A1- 19 916 380
- DE-A1-102007 010 239
- DE-A1-102007 012 915

## Beschreibung

Die Erfindung betrifft ein piezoelektrisches Keramikmaterial, und ein Verfahren zur Herstellung des piezoelektrischen Keramikmaterials. Des Weiteren betrifft die Erfindung ein piezoelektrisches Vielschichtbauelement, welches ein solches piezoelektrisches Keramikmaterial umfasst, sowie ein Herstellungsverfahren für dieses piezoelektrische Vielschichtbauelement.

DE 102007012915 A1 offenbart ein piezoelektrisches Keramikmaterial der folgenden Zusammensetzung (Pb_{a-b}Mb)[(Zn_{1/3}Nb_{2/3})ₓTi_{y}Zr_{z}]O₃, worin 0.96 ≤ a ≤ 1.03, 0 < b ≤ 0.1, 0.005 ≤ x < 0.05, 0.42 ≤ y ≤ 0.53, 0.45 ≤ z ≤ 0.56, x + y + z = 1 und M aus Sr, Ca, Ba ausgewählt ist, mit Zusätzen von ≤ 0.5 % Cu (ausgedrückt als Cu₂O) und ≤ 0.4 % Ag (ausgedrückt als Ag₂O).

WO 2006/110722 A1 beschreibt eine modifizierte PZT-Piezokeramik vom Typ PbₓSr₁₋ₓ(Mn_{1/3}Sb_{2/3})_{1-y}(Zr_{z}Ti_{1-z})_{y}O₃ mit x ≈ 0.96, y ≈ 0.94, z ≈ 0.5 und CuO- und Nb₂O₅-Dotierung

Aus DE 19916380 A1 ist eine Piezokeramik des Typs Pbₐ[Cr_{y}Nb_{(1-x)y}zr_{1-b-y}Ti_{b}]O₃ bekannt, worin 0.95 ≤ a ≤ 1.05, 0.4 ≤ b ≤ 0.55, 0.1 ≤ x ≤ 0.7, 0.02 ≤ y ≤ 0.12 gilt und Cu in einer Menge von 0.05-3 % (ausgedrückt als CuO) zugesetzt ist. Hierin können bis zu 3 % des Pb durch Sr, Ca, Ba ersetzt sein.

DE 102007010239 A1 offenbart PZT mit Erdalkali-Niobat-Zusatz.

Es wird ein piezoelektrisches Keramikmaterial nach dem Anspruch 1 angegeben.

Eine zu lösende Aufgabe besteht darin, ein piezoelektrisches Keramikmaterial anzugeben, das über eine optimierte Gefügestruktur verfügt.

Solche piezoelektrische Keramikmaterialien, welche über eine optimierte Gefügestruktur verfügen, finden beispielsweise Anwendung bei der Herstellung von piezokeramischen Vielschichtbauelementen mit Innenelektroden. Solche piezokeramischen Vielschichtbauelemente können beispielsweise über gemeinsame Sinterung von übereinander gestapelten keramischen Grünfolien mit dazwischen liegenden Innenelektroden erhalten werden.

Die Aufgabe wird durch ein piezoelektrisches Keramikmaterial nach Anspruch 1 gelöst. Weitere Ausführungsformen des piezoelektrischen Keramikmaterials sowie ein Verfahren zu dessen Herstellung, sowie ein Vielschichtbauelement umfassend dieses Keramikmaterial und Herstellungsverfahren für das Vielschichtbauelement sind Gegenstand weiterer abhängiger Patentansprüche.

Eine Ausführungsform der Erfindung betrifft ein piezoelektrisches Keramikmaterial der allgemeinen Formel:

P_{1-c-d}D_{c}Z_{d} (PbO)_{w}

für die gilt: 0 < c ≤ 0,025; 0 ≤ d ≤ 0,05; 0 ≤ w ≤ 0,05;
- wobei P für eine Verbindung der Formel [Pb₁₋ᵥAg^{I}ᵥ] [(Zr_{1-y}Ti_{y})₁₋ᵤCu^{II}ᵤ]O₃ steht, mit 0,50 ≤ 1-y ≤ 0,60; 0 < u ≤ 0,0495; 0 ≤ v ≤ 0,02, und
- D für eine Komponente der allgemeinen Formel steht:

   [(M¹O)₁₋ₚ(M²O)ₚ]ₐ[Nb₂O₅]₁₋ₐ

   wobei
   -- M¹ für Ba₁₋ₜSrₜ steht, mit 0 ≤ t ≤ 1,
   -- M² für Sr und/oder Ca steht,
   -- und es gilt 0 < p < 1 und 2/3 < a < 1, und
- Z für eine Verbindung der allgemeinen Formel steht:

   Pb(LₗRᵣ)O₃
wobei L in der Oxidationsstufe II oder III vorliegt, und R in der Oxidationsstufe VI oder V, und gilt:
L^{II} ausgewählt ist aus Fe, Mg, Co, Ni oder Cu in Kombination mit R^{VI} = W, mit 1 = 1/2 und r = 1/2, oder
L^{III} ausgewählt ist aus Fe, Cr oder Ga in Kombination mit R^{v} = Nb, Ta oder Sb, mit 1 = 1/2 und r = 1/2, oder
L^{III} ausgewählt ist aus Fe, Cr oder Ga in Kombination mit R^{VI} = W, mit 1 = 2/3 und r = 1/3.

Durch die Anwesenheit des Cu^{II}, und gegebenenfalls des Ag^{I}, wird eine verbesserte Gefügeausbildung erzielt. Hierdurch werden die piezoelektrischen Eigenschaften des Keramikmaterials verbessert. Es wird eine höhere Sinterverdichtung und ein optimiertes Kornwachstum erreicht, was zu einer Verbesserung der piezoelektrischen Eigenschaften führt. Der Sintervorgang kann auch bereits in einem Temperaturbereich von 900 °C bis 950 °C durchgeführt werden. Dadurch wird es möglich, dass das piezoelektrische Keramikmaterial zur Herstellung von piezoelektrischen Vielschichtbauelementen verwendet werden kann, die kostengünstige Innenelektroden mit einem beispielsweise geringen Pd-Gehalt, wie z.B. Pd₅Ag₉₅ aufweisen können. Dieses kann unter Luftatmosphäre gesintert werden. Das piezoelektrische Keramikmaterial kann bedingt durch die Zusatzkomponente D und die Ag⁺-Dotierung und Cu²⁺-Dotierung unter den Bedingungen einer Gemeinsamsinterung mit den Innenelektroden eine hohe Sinteraktivität erzielen. Diese beruht maßgeblich auf der im thermischen Prozess auftretenden Bildung von Sauerstoff-Leerstellen in der Komponente P, die zur Ausbildung eines hinreichend dichten Keramikgefüges bei zugleich ausreichender mittlerer Korngröße führt. Dadurch können beim Übergang in den ferroelektrischen Zustand unterhalb der Curietemperatur Domänen ausgebildet werden, die frei von unkontrollierten Defekten im Korngefüge sind. Diese zeichnen sich dann durch eine hinreichende Mobilität und hohe Reversibilität aus.

Somit kann durch das piezoelektrische Keramikmaterial unter den Bedingungen einer Gemeinsamsinterung mit den Innenelektroden eine hohe Sinteraktivität erzielt werden, die zur Ausbildung eines hinreichend dichten Keramikgefüges bei zugleich ausreichender mittlerer Korngröße führt. Es können ferroelektrische Domänen, die frei von unkontrollierten Defekten im Korngefüge sind, erzeugt werden. Diese zeichnen sich durch eine hinreichende Mobilität im elektrischen Feld und durch hohe Reversibilität aus.

In einer weiteren Ausführungsform dient die Verbindung P als Wirtsgitter für die weiteren Komponenten, wodurch dieses durch die allgemeine Formel des Perowskit-Gitters ABO₃ beschrieben werden kann.

Piezoelektrische Keramikmaterialien des Perowskit-Gitter-Typs zeichnen sich durch besonders gute piezoelektrische Eigenschaften aus.

In einer weiteren Ausführungsform gilt für u: 0 < u ≤ 0,015.

Für einen Anteil an Cu^{II} im angegebenen Bereich konnten besonders gute piezoelektrische Eigenschaften für das Keramikmaterial erzielt werden. Oberhalb einer bestimmten Grenze des Dotierungsmaterials Cu^{II} ist der Einbau in das Perowskit-Kristall-Wirtsgitter nicht mehr gegeben. Dies hat zur Folge, dass ein Phasenzerfall eintritt und beispielsweise die Sauerstoff-Leerstellen beim Abkühlen des piezoelektrischen Keramikmaterials nur noch unvollständig durch eintretenden Sauerstoff besetzt werden. Hierdurch resultieren aufgrund von Ionenleitfähigkeiten Nachteile im Isolationswiderstand und in der Langzeitstabilität.

In einer weiteren Ausführungsform der Erfindung gilt für v: 0 < v ≤ 0,010.

Im Zusammenhang mit dem Dotierstoff Ag^{I} und dessen Konzentration gilt Entsprechendes, was zuvor in Zusammenhang mit Cu^{II} beschrieben wurde. Auch hier hat das Überschreiten einer Obergrenze zur Folge, dass die Ionen nicht mehr in das Perowskit-Kristall-Gitter eingebaut werden können und ein Phasenzerfall eintritt.

Durch die Dotierung sowohl mit Cu^{II} wie auch mit Ag^{I} können in Bezug auf das Kornwachstum und die Sinterverdichtung synergetische Effekte eintreten. Es kann eine nochmalige Erhöhung der Sauerstoff-Leerstellen-Konzentration während des Sinterprozesses erzielt werden.

In einer weiteren Ausführungsform der Erfindung gilt für v: v = 0.

Bereits durch den Zusatz von Cu^{II}, auch ohne den zusätzlichen Zusatz von Ag^{I}, kann die Ausbildung von Sauerstoff-Leerstellen während des Sinterprozesses erreicht werden. Diese Sauerstoff-Leerstellen-Ausbildung optimiert das Kornwachstum und führt zu einer Sinterverdichtung zugunsten einer vorteilhaften Gefügeausbildung. Diese hat wiederum eine Verbesserung der piezoelektrischen Eigenschaften zur Folge.

In einer weiteren Ausführungsform der Erfindung ist t = 1 und steht M² für Sr.

Somit umfasst die Komponente D Sr als einziges Erdalkalimetall. Für piezoelektrische Keramikmaterialien, in denen die Komponente D die Elemente Sr und Nb umfasst, konnten besonders gute Ergebnisse erzielt werden. Hierbei kann es sich beispielsweise um [Sr₄(Sr_{4/3}Nb_{8/3})O₁₂] handeln. Während des Herstellungsprozesses können auch in der Komponente D Sauerstoff-Leerstellen ausgebildet werden, so dass beispielsweise [Sr₄(Sr_{5/3}Nb_{7/3})O_{11,5}V_{o;0,5}] ausgebildet wird. Der Zusatz von Cu über die Zusatzkomponente Z trägt nicht zur Bildung von Sauerstoff-Leerstellen bei, da diese Komponenten die Gegenionen zur Ladungskompensation jeweils mit einbringen. Lediglich durch den Zusatz von CuO oder Cu₂O kann die gewünschte Ausbildung von Sauerstoff-Leerstellen während des Herstellungsprozesses erzielt werden.

In einem weiteren Ausführungsbeispiel der Erfindung ist L ausgewählt aus: Fe, Mg, Co, Ni, Cr, Li oder Kombinationen davon.

Neben dem piezoelektrischen Keramikmaterial wird auch ein piezoelektrisches Vielschichtbauelement beansprucht, welches eines der zuvor beschriebenen Keramikmaterialien umfasst.

In einem Ausführungsbeispiel umfasst das piezoelektrische Vielschichtbauelement Innenelektroden, umfassend mindestens eines der Elemente ausgewählt aus: Ag, Pd, Cu sowie Keramikschichten, welche ein zuvor beschriebenes Keramikmaterial umfassen.

Aufgrund der sehr guten Gefügeausbildung des piezoelektrischen Keramikmaterials und der damit verbundenen verbesserten piezoelektrischen Eigenschaften können somit piezoelektrische Vielschichtbauelemente gefertigt werden, welche ihrerseits über verbesserte piezoelektrische Eigenschaften verfügen. Diese können beispielsweise über Ag-, Ag/Pd- oder Cu-Innenelektroden verfügen.

Das piezoelektrische Vielschichtbauelement kann beispielsweise über Gemeinsamsinterung der Keramikschichten mit den Innenelektroden hergestellt werden. Hierbei können beispielsweise kostengünstige Innenelektroden mit einem geringen Pd-Gehalt, wie beispielsweise Pd₅Ag₉₅, zur Anwendung kommen, da das piezoelektrische Keramikmaterial bereits bei einer Sintertemperatur von 900 °C bis 950 °C sehr gute piezoelektrische Eigenschaften aufweist. Sowohl durch das Absenken des Pd-Gehalts in den Innenelektroden, wie auch durch die reduzierte Sintertemperatur, können jeweils Kosten eingespart werden.

Neben dem piezoelektrischen Keramikmaterial wird auch ein Verfahren zu dessen Herstellung beansprucht.

In einer Variante des Verfahrens zur Herstellung eines zuvor beschriebenen piezoelektrischen Keramikmaterials umfasst dieses die Verfahrensschritte: Bereitstellen der Edukte als Verfahrensschritt A), Zerkleinern und Mischen der Edukte aus A), sodass ein Gemisch entsteht als Verfahrensschritt B), Formen von Grünfolien aus dem Gemisch aus B) als Verfahrensschritt C), und Sintern der Grünfolien aus C) als Verfahrensschritt D).

Die Erfinder haben erkannt, dass durch den Zusatz von Cu₂O bzw. CuO und gegebenenfalls zusätzlich von Ag₂O es zur Ausbildung von Sauerstoff-Leerstellen kommt. Des Weiteren haben sie festgestellt, dass diese Sauerstoff-Leerstellen das Kornwachstum und die Sinterverdichtung zugunsten einer vorteilhaften Gefügeausbildung fördern. Die Dotierung von Cu^{II} und Ag^{I} muss hierbei mit einer bestimmten Konzentration erfolgen, da oberhalb dieser Konzentration der isomorphe Einbau in das Perowskit-Mischkristall-Wirtsgitter nicht mehr gegeben ist, wodurch ein Phasenzerfall eintritt. Tritt ein solcher Phasenzerfall ein, können die Sauerstoff-Leerstellen beim Abkühlen nur noch unvollständig durch eintretenden Sauerstoff ersetzt werden, wobei aufgrund von Ionenleitfähigkeit Nachteile im Isolationswiderstand und in der Langzeitstabilität resultieren.

Die Leerstellenkonzentration hat einen starken Einfluss auf die Volumendiffusion während des Sinterprozesses. Die Volumendiffusion ist wiederum eine Voraussetzung dafür, dass während des Sinterverfahrens die gewünschte Sinterverdichtung erzielt wird.

Die Erfinder haben somit einen Weg gefunden ein piezoelektrisches Keramikmaterial herzustellen, welches im fertigen Zustand keine Sauerstoff-Leerstellen aufweist, diese jedoch während des Sinterprozesses im Keramikmaterial vorliegen, wodurch es zu einer verstärkten Volumendiffusion im Material kommen kann und somit eine erhöhte Sinterverdichtung und ein verbessertes Kornwachstum erzielt werden können. Beim Abkühlen an der Luft werden die Sauerstoff-Leerstellen gegen Ende des Herstellungsprozesses durch eintretenden Sauerstoff aufgefüllt. Die Sauerstoff-Zentren können hierbei als Elektronenfalle (Akzeptor) wirken. Der Isolationswiderstand wird hierdurch signifikant erhöht. Würden im fertigen piezoelektrischen Keramikmaterial noch Sauerstoff-Leerstellen verbleiben, wäre infolge Sauerstoff-Ionenleitfähigkeit die Langzeitstabilität der Keramik nicht gegeben.

Im Verfahrensschritt A) können die Edukte aus den einzelnen Elementen bestehen, welche als Oxide oder Salze vorgelegt werden können, aber es können auch Precursor bereitgestellt werden. Bei den Precursoren kann es sich beispielsweise um die Komponenten P, D und gegebenenfalls Z handeln, welche in vor gelagerten Verfahren bereits gefertigt wurden.

Die Edukte werden im Verfahrensschritt A) im entsprechenden Molverhältnis je nach dem angestrebten piezoelektrischen Keramikmaterial bereitgestellt.

In einer weiteren Variante des Verfahrens wird das Cu aus CuO und/oder Cu₂O während des Sinterns als Cu^{II} in das Keramikmaterial eingebaut.

Durch den Einsatz von CuO und/oder Cu₂O wird vermieden, dass neben dem Cu ein weiterer Bestandteil/Elemente mit in das piezoelektrische Keramikmaterial eingebracht wird, welches die Ladung des Cu kompensieren könnte. Das Vermeiden der Ladungskompensation ist eine wichtige Voraussetzung zur Ausbildung von Sauerstoff-Leerstellen. Die Ausbildung von Sauerstoff-Leerstellen kann somit durch Verbindungen, wie sie beispielsweise für die Komponente Z zur Auswahl stehen, auch für den Fall, dass L als Cu gewählt wird, nicht erreicht werden.

In einer weiteren Variante des Verfahrens werden durch den Einbau des Cu^{II} in das Keramikmaterial Sauerstoff-Leerstellen im Keramikmaterial ausgebildet, sodass im Verfahren eine Zwischenstufe gemäß der allgemeinen Formel ausgebildet wird: Pb[(Zr_{1-y}Ti_{y})₁₋ᵤCu^{II}u]O₃₋ᵤV_{O;u}, wobei V_{O} für eine SauerstoffLeerstelle steht und es gilt: 0 < u ≤ 0,0495.

In einer weiteren Variante des Verfahrens wird Ag₂O als weiteres Edukt verwendet, und das Ag wird während des Sinterns als Ag^{I} in das Keramikmaterial eingebaut, sodass im Verfahren eine Zwischenstufe gemäß der allgemeinen Formel ausgebildet wird: [Pb₁₋ᵥAg^{I}ᵥ] [(Zr_{1-y}Ti_{y}) ₁₋ᵤCu^{II}ᵤ] O_{3-u+0,5v}V_{O;u-0,5v}, und es gilt: 0 < v ≤ 0,02.

In einer weiteren Variante des Verfahrens werden die Sauerstoff-Leerstellen beim Abkühlen nach dem Sintern durch Sauerstoff aus der Luft aufgefüllt.

Die Sauerstoff-Leerstellen können somit direkt mit dem Sauerstoff aus der Luft aufgefüllt werden. Es bedarf somit keiner internen, also im Keramikmaterial vorhandenen, Sauerstoffquelle.

In einer weiteren Variante des Verfahrens wird durch die Sauerstoff-Leerstellen die Volumendiffusion während des Sinterprozesses erhöht.

Eine gute Volumendiffusion ist eine Voraussetzung dafür, dass während des Sinterprozesses eine gute Sinterverdichtung erzielt wird.

Im Folgenden soll eine Variante der Erfindung anhand einer Figur näher erläutert werden.

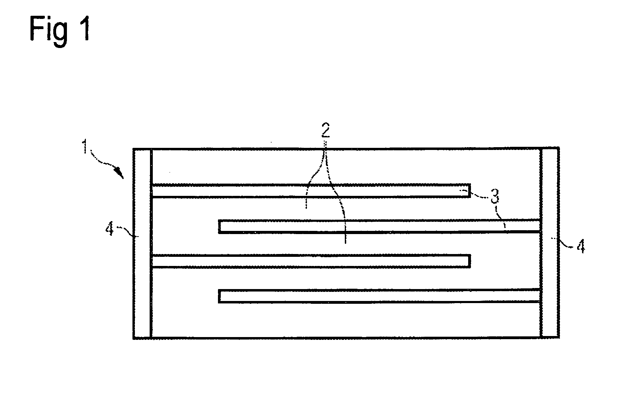

Figur 1 zeigt einen schematischen Querschnitt durch ein piezoelektrisches Vielschichtbauelement.

Figur 1 zeigt einen schematischen Querschnitt eines piezoelektrischen Vielschichtbauelements 1, welches Keramikschichten 2 umfasst, welche ein piezoelektrisches Keramikmaterial umfasst, wie es zuvor beschrieben wurde. Das piezoelektrische Vielschichtbauelement 1 umfasst des Weiteren Innenelektroden 3, welche alternierend zwischen den Keramikschichten 2 angeordnet sind. Die Innenelektroden 3 sind alternierend jeweils mit einer Außenelektrode 4 elektrisch leitend verbunden.

Ein solches piezoelektrisches Vielschichtbauelement 1 kann beispielsweise mittels einer der zuvor beschriebenen Herstellungsverfahren hergestellt werden. Für die Innenelektroden 3 kann beispielsweise Pd₅Ag₉₅ verwendet werden.

Ein solches piezoelektrisches Vielschichtbauelement 1 kann beispielsweise in der Automobilindustrie zur Steuerung der Kraftstoffzufuhr in Verbrennungsmotoren eingesetzt werden. Die Erfindung ist nicht durch die Beschreibung anhand der Ausführungsbeispiele beschränkt.

### Bezugszeichenliste

- 1): piezoelektrisches Vielschichtbauelement
- 2): Keramikschichten
- 3): Innenelektroden
- 4): Außenelektroden

## Patentansprüche

1. Piezoelektrisches Keramikmaterial der allgemeinen Formel:
P_{1-c-d}D_{c}Z_{d}(PbO)_{w}
für die gilt: 0 < c ≤ 0,025; 0 ≤ d ≤ 0,05; 0 ≤ w ≤ 0,05;
- wobei P für eine Verbindung der Formel [Pb₁₋ᵥAg^{I}ᵥ] [(Zr_{1-y}Ti_{y})₁₋ᵤCu^{II}ᵤ]O₃ steht, mit 0,50 ≤ 1-y ≤ 0,60; 0 < u ≤ 0,0495; 0 ≤ v ≤ 0,02, und
- D für eine Komponente der allgemeinen Formel steht:
[(M¹O)₁₋ₚ(M²O)ₚ]ₐ [Nb₂O₅]₁₋ₐ
wobei
-- M¹ für Ba₁₋ₜSrₜ steht, mit 0 ≤ t ≤ 1,
-- M² für Sr und/oder Ca steht,
-- und es gilt 0 < p < 1 und 2/3 < a < 1, und
- Z für eine Verbindung der allgemeinen Formel steht:
Pb(LₗRᵣ)O₃
wobei L in der Oxidationsstufe II oder III vorliegt, und R in der Oxidationsstufe VI oder V, und gilt:
L^{II} ausgewählt ist aus Fe, Mg, Co, Ni oder Cu in Kombination mit R^{VI} = W, mit 1 = 1/2 und r = 1/2, oder
L^{III} ausgewählt ist aus Fe, Cr oder Ga in Kombination mit R^{V} = Nb, Ta oder Sb, mit 1 = 1/2 und r = 1/2, oder
L^{III} ausgewählt ist· aus Fe, Cr oder Ga in Kombination mit R^{VI} = W, mit 1 = 2/3 und r = 1/3.

2. Keramikmaterial nach Anspruch 1,
wobei die Verbindung P als Wirtsgitter für die weiteren Komponenten dient und durch die allgemeine Formel des Perowskit-Gitters ABO₃ beschrieben werden kann.

3. Keramikmaterial nach einem der vorhergehenden Ansprüche,
wobei für u gilt: 0 < u ≤ 0,015.

4. Keramikmaterial nach einem der Ansprüche 1 bis 3,
wobei für v gilt: 0 < v ≤ 0,010.

5. Keramikmaterial nach einem der Ansprüche 1 bis 3,
wobei für v gilt: v = 0.

6. Keramikmaterial nach einem der vorhergehenden Ansprüche,
wobei t = 1 ist und M² für Sr steht.

7. Keramikmaterial nach einem der Ansprüche 1 bis 6,
wobei L ausgewählt ist aus: Fe, Mg, Co, Ni, Cr, Li oder Kombinationen davon.

8. Piezoelektrisches Vielschichtbauelement, umfassend
- Innenelektroden umfassend mindestens eines der Elemente ausgewählt aus: Ag, Pd, Cu;
- Keramikschichten umfassend ein Keramikmaterial nach einem der Ansprüche 1 bis 7.

9. Verfahren zur Herstellung eines piezoelektrischen Keramikmaterials nach einem der Ansprüche 1 bis 7 umfassend die Verfahrensschritte:
A) Bereitstellen der Edukte,
B) Zerkleinern und Mischen der Edukte aus A), so dass ein Gemisch entsteht,
C) Formen von Grünfolien aus dem Gemisch aus B),
D) Sintern der Grünfolien aus C).

10. Verfahren nach Anspruch 9,
wobei das Cu aus CuO und/oder Cu₂O während des Sinterns als Cu^{II} in das Keramikmaterial eingebaut wird.

11. Verfahren nach Anspruch 10,
wobei durch den Einbau des Cu^{II} in das Keramikmaterial Sauerstoffleerstellen im Keramikmaterial ausgebildet werden, so dass im Verfahren eine Zwischenstufe gemäß der allgemeinen Formel ausgebildet wird: Pb[(Zr_{1-y}Ti_{y})₁₋ᵤCu^{II}ᵤ] O₃₋ᵤV_{O;u},
wobei Vo für eine Sauerstoffleerstelle steht und es gilt: 0 < u ≤ 0,0495.

12. Verfahren nach Anspruch 11,
wobei Ag₂O als weiteres Edukt verwendet wird, und das Ag während des Sinterns als Ag^{I} in das Keramikmaterial eingebaut wird, so dass im Verfahren eine Zwischenstufe gemäß der allgemeinen Formel ausgebildet wird:
[Pb₁₋ᵥAg^{I}ᵥ] [( Zr_{1-y}Ti_{y})₁₋ᵤCu^{II}ᵤ]O_{3-u+0,5v}V_{O;u-0,5v}, und es gilt: 0 < v ≤ 0,02.

13. Verfahren nach einem der Ansprüche 11 oder 12,
wobei die Sauerstoffleerstellen beim Abkühlen nach dem Sintern durch Sauerstoff aus der Luft aufgefüllt werden.

14. Verfahren nach einem der Ansprüche 11 oder 13,
wobei durch die Sauerstoffleerstellen die Volumendiffusion während des Sinterprozesses erhöht wird.

## Claims

1. Piezoelectric ceramic material of the general formula:
P_{1-c-d}D_{c}Z_{d} (PbO)_{w}
where: 0 < c ≤ 0.025; 0 ≤ d ≤ 0.05; 0 ≤ w ≤ 0.05;
- wherein P is a compound of the formula [Pb₁₋ᵥAg^{I}ᵥ] [(Zr_{1-y}Ti_{y})₁₋ᵤCu^{II}ᵤ]O₃, where 0.50 ≤ 1-y ≤ 0.60; 0 < u ≤ 0.0495; 0 ≤ v ≤ 0.02, and
- D is a component of the general formula:
[(M¹O)₁₋ₚ(M²O)ₚ]ₐ[Nb₂O₅]₁₋ₐ
where
-- M¹ is Ba₁₋ₜSrₜ, where 0 ≤ t ≤ 1,
-- M² is Sr and/or Ca,
-- and 0 < p < 1 and 2/3 < a < 1, and
- Z is a compound of the general formula:
Pb(LₗRᵣ)O₃
where L is present in the oxidation state II or III and R is in the oxidation state VI or V, and:
L^{II} is selected from among Fe, Mg, Co, Ni and Cu in combination with R^{VI} = W, where l = 1/2 and r = 1/2, or
L^{III} is selected from among Fe, Cr and Ga in combination with R^{V} = Nb, Ta or Sb, where l = 1/2 and r = 1/2, or
L^{III} is selected from among Fe, Cr and Ga in combination with R^{VI} = W, where l = 2/3 and r = 1/3.

2. Ceramic material according to Claim 1, wherein the compound P serves as host lattice for the further components, and can be described by the general formula of the perovskite lattice ABO₃.

3. Ceramic material according to either of the preceding claims, wherein u obeys: 0 < u ≤ 0.015.

4. Ceramic material according to any of Claims 1 to 3, wherein v obeys: 0 < v ≤ 0.010.

5. Ceramic material according to any of Claims 1 to 3, wherein v obeys: v = 0.

6. Ceramic material according to any of the preceding claims, wherein t = 1 and M² is Sr.

7. The ceramic material according to any of Claims 1 to 6, wherein L is selected from among: Fe, Mg, Co, Ni, Cr, Li and combinations thereof.

8. Piezoelectric multilayer component comprising
- internal electrodes comprising at least one element selected from among: Ag, Pd, Cu;
- ceramic layers comprising a ceramic material according to any of Claims 1 to 7.

9. Process for producing a piezoelectric ceramic material according to any of Claims 1 to 7, which comprises the process steps:
A) provision of the starting materials,
B) comminution and mixing of the starting materials from A) to form a mixture,
C) formation of green sheets from the mixture from B),
D) sintering of the green sheets from C).

10. Process according to Claim 9, wherein the Cu from CuO and/or Cu₂O is incorporated as Cu^{II} into the ceramic material during sintering.

11. Process according to Claim 10, wherein oxygen vacancies are formed in the ceramic material by incorporation of Cu^{II} into the ceramic material, so that an intermediate having the general formula:
Pb [(Zr_{1-y}Ti_{y})₁₋ᵤCu^{II}ᵤ]O₃₋ᵤV_{O;u},
where Vo is an oxygen vacancy and: 0 < u ≤ 0.0495, is formed in the process.

12. Process according to Claim 11, wherein Ag₂O is used as further starting material and the Ag is incorporated as Ag^{I} into the ceramic material during sintering, so that an intermediate having the general formula:
[Pb₁₋ᵥAg^{I}ᵥ] [(Zr_{1-y}Ti_{y})₁₋ᵤCu^{II}ᵤ)O_{3-u+0.5v}V_{O;u-0.5v},
where: 0 < v ≤ 0.02, is formed in the process.

13. Process according to either Claim 11 or 12, wherein the oxygen vacancies are filled by oxygen from the air during cooling after sintering.

14. Process according to either Claim 11 or 13, wherein the volume diffusion during the sintering process is increased by the oxygen vacancies.

## Revendications

1. Matériau céramique piézoélectrique de la formule générale:
P_{1-c-d}D_{c}Z_{d}(PbO)_{w}
pour laquelle on a: 0 < c ≤ 0,025; 0 ≤ d ≤ 0,05: 0 ≤ w ≤ 0,05;
- dans laquelle P représente un composé de la formule [Pb₁₋ᵥAg^{I}ᵥ][(Zr_{1-y}Ti_{y}) ₁₋ᵤCu^{II}ᵤ]O₃,
avec 0,50 ≤ 1-y ≤ 0,60; 0 < u ≤ 0,0495; 0 ≤ v ≤ 0,02, et
- D représente un composé de la formule générale:
[(M¹O)₁₋ₚ(M²O)ₚ]ₐ[Nb₂O₅]₁₋ₐ
dans laquelle
-- M¹ représente Ba₁₋ₜSrt, avec 0 ≤ t ≤ 1,
-- M² représente Sr et/ou Ca,
-- et on a: 0 < p < 1 et 2/3 < a < 1, et
- Z représente un composé de la formule générale:
Pb (LₗRᵣ)O₃
dans laquelle L se trouve au niveau d'oxydation II ou III, et R se trouve au d'oxydation VI ou V, et on a:
L^{II} est sélectionné parmi Fe, Mg, Co, Ni ou Cu, en combinaison avec R^{VI} = W, avec 1 = 1/2 et r = 1/2, ou
L^{III} est sélectionné parmi Fe, Cr ou Ga en combinaison avec R^{V} = Nb, Ta ou Sb, avec l = 1/2 et r = 1/2, ou
L^{III} est sélectionné parmi Fe, Cr ou Ga en combinaison avec R^{VI} = W, avec 1 = 2/3 et r = 1/3.

2. Matériau céramique selon la revendication 1, dans lequel le composé P sert de réseau de la matrice et peut être décrit par la formule générale du réseau pérovskite ABO₃.

3. Matériau céramique selon l'une quelconque des revendications précédentes, dans lequel on a pour u: 0 < u ≤ 0,015.

4. Matériau céramique selon l'une quelconque des revendications 1 à 3, dans lequel on a pour v: 0 < v ≤ 0,010.

5. Matériau céramique selon l'une quelconque des revendications 1 à 3, dans lequel on a pour v: v = 0.

6. Matériau céramique selon l'une quelconque des revendications précédentes, dans lequel t = 1 et M² est Sr.

7. Matériau céramique selon l'une quelconque des revendications 1 à 6, dans lequel L est choisi parmi Fe, Mg, Co, Ni, Cr, Li ou des combinaisons de ceux-ci.

8. Composant multicouche piézoélectrique, comprenant
- des électrodes intérieures comprenant au moins un des éléments sélectionnés parmi: Ag, Pd, Cu;
- des couches céramiques comprenant un matériau céramique selon l'une quelconque des revendications 1 à 7.

9. Procédé de fabrication d'un matériau céramique piézoélectrique selon l'une quelconque des revendications 1 à 7, comprenant les étapes suivantes:
A) préparation des éduits,
B) broyage et mélange des éduits issus de A), de façon à former un mélange,
C) formage de feuilles crues composées du mélange issu de B),
D) frittage des feuilles crues issues de C).

10. Procédé selon la revendication 9, dans lequel le Cu est incorporé dans le matériau céramique sous forme de Cu^{II} à partir de CuO et/ou de Cu₂O pendant le frittage.

11. Procédé selon la revendication 10, dans lequel, par l'incorporation du Cu^{II} dans le matériau céramique, on crée des lacunes d'oxygène dans le matériau céramique, de telle manière que l'on forme dans le procédé une étape intermédiaire selon la formule générale: Pb [ (Zr_{1-y}Ti_{y}) ₁₋ᵤCu^{II}ᵤ] O₃₋ᵤV_{O;u},
dans laquelle V_{O} représente une lacune d'oxygène et on a: 0 < u ≤ 0,0495.

12. Procédé selon la revendication 11, dans lequel on utilise Ag₂O comme autre éduit, et l'Ag est incorporé dans le matériau céramique sous forme de Ag^{I} pendant le frittage, de telle manière que l'on forme dans le procédé une étape intermédiaire selon la formule générale: [Pb₁₋ᵥAg^{I}ᵥ] [ (Zr_{1-y}Ti_{y}) ₁₋ᵤCU^{II}ᵤ] O_{3-u+0,5v}V_{O;u-0,5v}, et on a: 0 < v ≤ 0,02.

13. Procédé selon l'une des revendications 11 ou 12, dans lequel on comble les lacunes d'oxygène avec de l'oxygène de l'air lors du refroidissement après le frittage.

14. Procédé selon l'une des revendications 11 ou 13, dans lequel on augmente la diffusion volumique pendant le processus de frittage par les lacunes d'oxygène.
